# EUROPÄISCHE PATENTSCHRIFT

(11) **EP 0 605 800 B1**
(45) Veröffentlichungstag und Bekanntmachung des Hinweises auf die Patenterteilung: **13.03.1996**
(21) Anmeldenummer: 93119644.8
(22) Anmeldetag: 06.12.1993
(51) Int. Cl.: H01C 17/00, H01C 1/14

(54) **Verfahren zum Herstellen von Widerständen aus Verbundmaterial und insbesondere nach diesem Verfahren hergestellte Widerstände**
Resistors from compound material and method for their fabrication
Résistances en matériel composite et procédé pour leur fabrication

(30) Priorität: 21.12.1992 DE 4243349
(43) Veröffentlichungstag der Anmeldung: 13.07.1994
(73) Patentinhaber: Isabellenhütte Heusler GmbH KG, D-35683 Dillenburg (DE)
(72) Erfinder: Hetzler, Ullrich, Dr., D-35683 Dillenburg-Oberscheid (DE)
(74) Vertreter: Heusler, Wolfgang, Dipl.-Ing.

(56) Entgegenhaltungen:
- EP-A- 0 437 239
- DE-A- 4 029 107
- US-A- 4 906 968
- IBM-TECHNICAL DISCLOSURE BULLETIN, Band 27, Nr. 1B, Juni 1984 G.SCHROTTKE and A.L. TALKINGTON:"Integral power resistors for aluminium substrate"

## Beschreibung

Die Erfindung betrifft elektrische Widerstände und ein Verfahren zur Herstellung von elektrischen Widerständen, insbesondere niederohmige Widerstände für Meßzwecke oder Nebenwiderstände.

Mit dem Spannungsabfall an niederohmigen, häufig im Milliohmbereich liegenden Widerständen lassen sich bekanntlich hohe Ströme messen. Zu diesem Zweck werden Bauelemente verwendet, bei denen ein metallisches Widerstandselement zwischen zwei Anschlußteilen aus Metall hoher Leitfähigkeit eingesetzt ist, und die gewöhnlich in Vierleitertechnik mit getrennten Strom-und Spannungsanschlüssen ausgebildet sind. Die Herstellung solcher Bauelemente erforderte bisher hohen Aufwand, da die Verbindung der verschiedenen Metallteile durch Hartlöten erfolgt. Überdies konnte die Herstellung nicht vollständig automatisiert erfolgen.

Aus Dokument DE-A-1 527 515 ist ein Verfahren zur Herstellung eines Verbudwerkstoffes bekannt, wobei ein Streifen aus einer Beryllium-Kupfer-Legierung mit einem zweiten Streifen aus Stahl Kante an Kante verschweißt wird.

Es ist Aufgabe der Erfindung, die Herstellung von insbesondere niederohmigen Widerständen einschließlich in Vierleitertechnik ausgebildeter Bauelemente mit guten elektrischen und mechanischen Eigenschaften in großen Stückzahlen ohne hohen Aufwand zu ermöglichen.

Diese Aufgabe wird durch die kennzeichnenden Merkmale der Patentansprüche gelöst.

Das Widerstandselement wird erfindungsgemäß durch Verschweißen mit den Anschlußteilen verbunden. Dies hat den Vorteil, daß eine sehr stabile, elektrisch sichere und im Vergleich mit der bisherigen Hartlöttechnik weniger aufwendige Verbindung hergestellt werden kann. Weiterhin hat die Erfindung den Vorteil, daß Widerstände aus einem Endlosband z.B. komplett in einem Stanz-Biege-Automaten gefertigt werden können. Das Verfahren zeichnet sich weiterhin dadurch aus, daß es im Unterschied zu anderen Herstellungsverfahren sehr flexibel ist, da die geometrischen Formen des Widerstandselements und der Anschlußteile nicht genau aufeinander abgestimmt sein müssen.

Ein besonderer Vorteil ergibt sich bei der Herstellung von Bauelementen in Vierleitertechnik, da die von dem Verbundmaterialband abgetrennten Widerstandsstücke mit ihren Anschlußteilen sehr einfach durch Weichlöten mit einer mit den erforderlichen Anschlüssen versehenen Unterlage verbunden werden können.

Darüberhinaus lassen sich erfindungsgemäß hergestellte Widerstände hoher Belastbarkeit sehr einfach und vorteilhaft nach Art der SMD-Technik ("Oberflächenmontage") auf Leiterplatten und sonstigen Trägermaterialien montieren. Bei dieser Technik werden die Bauelemente bekanntlich nicht mit z.B. drahtartigen Anschlußbeinchen an die zugehörigen externen Leitungen angeschlossen, sondern unter Verwendung von Lötzinn oder sonstigem Weichlötmaterial mit flachen Kontaktelementen auf flache Anschlußleiter aufgelötet, im vorliegenden Fall mit den angeschweißten ebenen Anschlußteilen.

Gemäß einem zweckmäßigen Ausführungsbeispiel des hier beschriebenen Verfahrens wird ein flaches Band z.B. aus einer CuMnNi-Legierung oder einer anderen konventionellen Widerstandslegierung vorzugsweise auf Kupferbasis gemeinsam mit einem Kupferband einer Schweißstation zugeführt, wo die beiden Bänder in an sich bekannter Weise im Durchlaufverfahren kontinuierlich an ihren Längskanten miteinander verschweißt werden. Häufig ist es zweckmäßig, nicht nur ein Kupferband auf einer Seite, sondern je ein Kupferband auf beiden Seiten des in der Mitte liegenden Bandes aus der Widerstandslegierung anzuschweißen. Es werden Bänder mit im wesentlichen rechteckigem Querschnitt verwendet, und je nach Anwendungsfall können Endlosbänder oder für eine bestimmte Anzahl von Widerständen bemessene Bänder verwendet werden. Beispielsweise können diese Bänder durch zweiseitiges Elektronenstrahlschweißen verbunden werden. Besonders bei dickeren Bändern kann man stattdessen auch ein Rollnahtschweißverfahren anwenden, bei dem die Bänder an ihren Rändern unter Druck aufeinandergerollt und gleichzeitig durch hohen elektrischen Strom erhitzt werden. Weitere bekannte Durchlauf- oder Nahtschweißverfahren sind ebenfalls anwendbar.

Es kann zweckmaßig sein, das fertig verschweißte Band anschließend zu walzen, so daß es aufgrund der Dickenreduzierung länger und breiter wird, ohne hierdurch an mechanischer und elektrischer Qualität zu verlieren.

Aus einem derart hergestellten Verbundmaterialband lassen sich dann durch Abtrennen von einzelnen Stücken eine Vielzahl von Widerständen gewinnen, die anschließend unverändert oder aber in die verschiedensten Formen zugeschnitten weiterverwendet werden können.

Unter Bezugnahme auf die Zeichnung wird die Erfindung nachstehend näher erläutert. Es zeigen:
- Fig. 1: einen erfindungsgemäß hergestellten Widerstand;
- Fig. 2: eine andere Ausführungsform eines erfindungsgemäß hergestellten Widerstands; und
- Fig. 3: die Verbindung eines aus einem Verbundmaterialband gewonnenen Widerstands mit einer Unterlage zur Schaffung eines Vierleiter-Meßwiderstands.

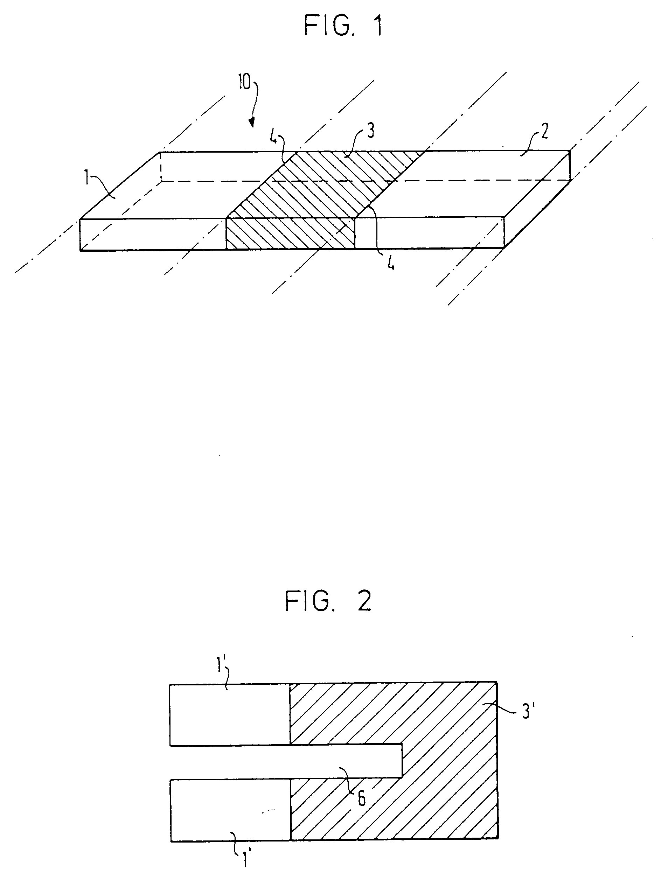

In Fig. 1 ist ein Widerstand 10 einfachster Art perspektivisch dargestellt, der erfindungsgemäß durch Abschneiden von einem in der oben beschriebenen Weise aus einem Widerstandsband und zwei Leitermaterialbändern erzeugten Verbundmaterialband quer zur Bandlängsrichtung hergestellt worden ist. Die Anschlußteile 1,2 bestehen also aus einem Metall hoher Leitfähigkeit, vorzugsweise Kupfer. Zwischen ihnen befindet sich das Widerstandselement 3 aus einem Bandstück mit rechteckförmigem Querschnitt. Die Geometrie der zu verbindenden Metallteile muß nicht notwendigerweise übereinstimmen. Vielmehr kann beispielsweise die Stärke oder die Breite der Anschlußteile 1,2 von der des Widerstandselements 3 abweichen. Vorzugsweise sind jedoch die Anschlußteile 1,2 und das Widerstandselement 3 plattenförmig ausgebildet mit einer Stärke der Anschlußteile 1 und 2 von z.B. 0,1 bis 1,5 mm und des Widerstandselements 3 von z.B. 0,1 bis 2 mm. Das Widerstandselement 3 ist entlang der Längsnähte 4 mit den Anschlußteilen 1,2 verschweißt.

Fig. 2 zeigt einen anderen, ebenfalls sehr einfachen Widerstand, der von einem in der beschriebenen Weise hergestellten, aber aus dem Widerstandslegierungsband und nur einem einzigen angeschweißten Kupferband od. dgl. bestehenden Verbundmaterialband stammt. Es handelt sich hier also um ein nur auf seiner einen Seite mit einem Anschlußteil verschweißtes Widerstandselement 3'. Ausgehend von dem in der Zeichnung linken in Bandlängsrichtung verlaufenden Rand des Leitermaterialteils wurde der dargestellte Einschnitt 6 durch diesen Teil hindurch senkrecht zur Bandlängsrichtung bis in das Widerstandselement 3' hinein erzeugt, beispielsweise durch Ausstanzen oder Fräsen, so daß das Widerstandselement 3' zwei voneinander getrennte Anschlußteile 1' aus dem Leitermaterial hat. Der Einschnitt 6 kann erzeugt werden, bevor oder auch nachdem das Widerstandsstück von dem Verbundmaterialband senkrecht zu dessen Längsrichtung abgeschnitten wird.

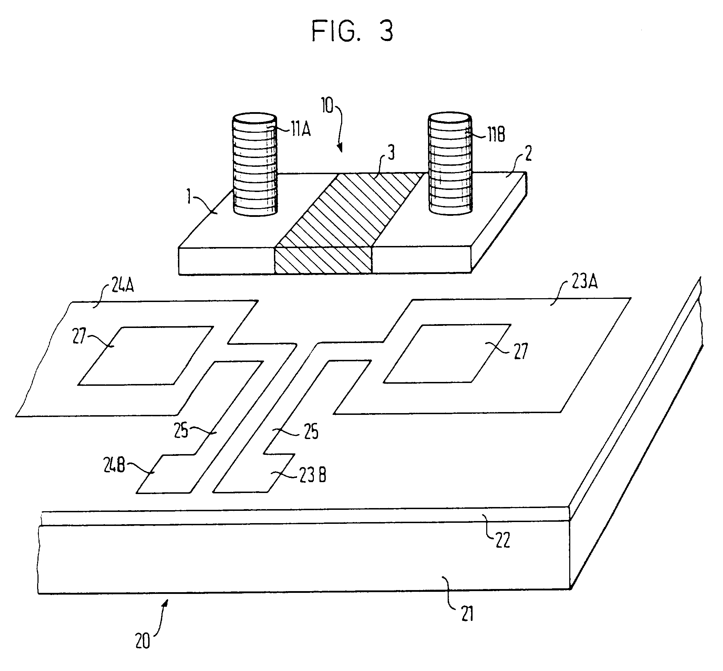

In Fig. 3 ist eine besonders vorteilhafte Verwendung eines nach dem beschriebenen Verfahren hergestellten Meßwiderstands 10 gemäß Fig. 1 dargestellt. Das Bauelement wird hier mit einer Platine 20 verbunden, die vorgefertigte Kontaktierungsflächen 23A, 23B, 24A und 24B aufweist, die mit einer elektronischen Meß- oder Auswerteschaltung verbunden werden können. Als Substrat dient vorzugsweise eine Glasfaser- oder Aluminiumplatte 21, die für eine gute Wärmeableitung sorgt. Auf einer isolierenden Deckschicht 22 sind großflächige, vorzugsweise aus Kupfer bestehende Kontaktierungsflächen 23A, 24A aufgebracht, von denen aus Leiterbahnen zu am Rand liegenden kleineren Kontaktierungsflächen 23B, 24B führen. Hierüber befindet sich eine weitere Isolierschicht (z.B. Lötstopplack, nicht dargestellt), die vorzugsweise die gesamte Oberfläche der Unterlage und insbesondere die Leiterbahnen 25 bedeckt, die zur Verbindung mit dem Widerstand 10 bzw. mit der externen Schaltung dienenden Kontaktierungsflächen 23A, 23B, 24A und 24B dagegen freiläßt. Die Anschlußteile 1,2 des Widerstands 10 werden durch Weichlot 27 mit den Kontaktierungsflächen 24A bzw. 23A verbunden. Der Strom kann über die Kontaktierungsflächen 23A, 24A zugeführt werden. Stattdessen können die Anschlußteile 1,2 des Widerstands 10 aber auch mit Schrauben 11A, 11B versehen werden, über die der Strom zugeführt wird.

Die Verbindung zwischen der Platine 20 und dem Widerstand 10 kann automatisch beispielsweise in einem Bestückungsautomaten erfolgen.

Weitere Vorteile des gemäß Fig. 3 hergestellten Bauelements sind einerseits die kleine, kompakte und mechanisch stabile Bauform und andererseits eine sehr niedrige Induktivität. Durch die Schweißverbindung des Widerstands 10 mit seinen Anschlußteilen 1,2 ergibt sich ferner eine hohe zeitliche Stabilität. Vorteilhaft ist weiterhin, daß die Auswerteelektronik in unmittelbarer Nähe des Widerstands auf der Platine 20 untergebracht werden kann, wodurch störende Einstreuungen weitgehend vermieden werden können.

## Patentansprüche

1. Elektrischer Widerstand, insbesondere niederohmiger Meßwiderstand, mit zwei voneinander getrennten Anschlußteilen (1,2) aus Metall hoher Leitfähigkeit, an die Leiter für den durch den Widerstand fließenden Strom anschließbar sind, und mit einem zwischen die Anschlußteile (1,2) eingesetzten, diese elektrisch und mechanisch verbindenden, aus einer Widerstandslegierung bestehenden Widerstandselement (3),
**dadurch gekennzeichnet**, daß die beiden Anschlußteile (1,2) und das Widerstandselement (3) plattenförmig ausgebildet und die beiden Anschlußteile (1,2) an die Kanten (4) des plattenförmigen Widerstandselements (3) angeschweißt sind.

2. Elektrischer Widerstand, insbesondere niederohmiger Meßwiderstand mit zwei voneinander getrennten Anschlußteilen (1') aus Metall hoher Leitfähigkeit, an die Leiter für den durch den Widerstand fließenden Strom anschließbar sind, und mit einem die Anschlußteile (1') elektrisch und mechanisch verbindenden, aus einer Widerstandslegierung bestehenden Widerstandselement (3'),
**dadurch gekennzeichnet**, daß die beiden Anschlußteile (1') und das Widerstandselement (3') plattenförmig ausgebildet und die beiden Anschlußteile (1') auf einer Seite des Widerstandselements (3') an dessen Kante angeschweißt sind,
wobei sich ein die beiden Anschlußteile (1') voneinander trennender Einschnitt (6) bis in das Widerstandselement (3') hinein erstreckt.

3. Elektrischer Widerstand, insbesondere niederohmiger Meßwiderstand, mit zwei voneinander getrennten Anschlußteilen (1,2) aus Metall hoher Leitfähigkeit, an die Leiter für den durch den Widerstand fließenden Strom und zusätzliche Leiter für den Spannungsabgriff anschließbar sind, und mit einem zwischen die Anschlußteile (1,2) eingesetzten, diese elektrisch und mechanisch verbindenden, aus einer Widerstandslegierung bestehenden Widerstandselement (3),
**dadurch gekennzeichnet**, daß die Anschlußteile (1,2) an das Widerstandselement (3) angeschweißt sind,
daß das Widerstandselement (3) auf einer Unterlage (21) angeordnet ist, die mit Kontaktierungsflächen (23A,23B) versehen ist, welche mit den Anschlußteilen (1,2) durch ein Weichlot verlötet sind,
und daß die Kontaktierungsflächen (23A,23B) durch von dem Widerstandselement (3) und den Anschlußteilen (1,2) isolierte Leiterbahnen mit gesonderten Anschlußflächen (24A,24B) verbunden sind.

4. Verfahren zum Herstellen von elektrischen Widerständen, insbesondere von niederohmigen Widerständen für Meßzwecke od. dgl., wobei ein aus einer Widerstandslegierung bestehendes Widerstandselement mit Anschlußteilen aus Leitermetall hoher elektrischer Leitfähigkeit verbunden wird,
**dadurch gekennzeichnet**, daß zunächst ein langes Band aus der Widerstandslegierung an mindestens einer seiner Längskanten durchgehend mit einem entsprechend langen Band aus dem Leitermetall verschweißt wird, so daß ein Band aus Verbundmaterial entsteht, und daß dieses Band dann zur Erzeugung einer Vielzahl einzelner Widerstandsstücke jeweils quer zur Bandlängsrichtung zertrennt wird.

5. Verfahren nach Anspruch 4, **dadurch gekennzeichnet**, daß die Bänder kontinuierlich beim Durchlaufen einer Schweißstation verschweißt werden.

6. Verfahren nach Anspruch 4 oder 5, **dadurch gekennzeichnet**, daß die Bänder durch Elektronenstrahlschweißen verbunden werden.

7. Verfahren nach Anspruch 4 oder 5, **dadurch gekennzeichnet**, daß die Bänder durch Rollnahtschweißen verbunden werden.

8. Verfahren nach einem der Ansprüche 4 bis 7, **dadurch gekennzeichnet**, daß auf beiden Seiten des Bandes aus der Widerstandslegierung jeweils ein Band aus dem Leitermetall angeschweißt wird.

9. Verfahren nach einem der Ansprüche 4 bis 8, **dadurch gekennzeichne**t, daß das Verbundmaterialband vor dem Abtrennen der Widerstandsstücke gewalzt wird, so daß es wesentlich länger und breiter wird.

10. Verfahren nach einem der Ansprüche 4 bis 9, **dadurch gekennzeichnet**, daß aus einem quer zur Bandlängsrichtung von dem Verbundmaterialband abgetrennten oder abzutrennenden Streifen durch einen Einschnitt, der sich ausgehend von einem in Bandlängsrichtung verlaufenden Rand des Leitermetallteils durch diesen Teil hindurch quer zur Bandlängsrichtung in den Legierungsteil erstreckt, ein Widerstandsstück mit voneinander getrennten Anschlußteilen aus dem Leitermetall gebildet wird.

11. Verfahren nach einem der Ansprüche 4 bis 10, **dadurch gekennzeichnet**, daß zur Erzeugung eines Widerstands mit Vierleiteranschlüssen das aus dem Verbundmaterialband abgetrennte Widerstandsstück auf einer mit metallischen Anschlußflächen hoher Leitfähigkeit versehenen Unterlage angeordnet wird und die aus dem Leitermetall bestehenden Anschlußteile des Widerstandsstücks mit Teilen dieser Anschlußflächen verlötet werden.

12. Verfahren nach Anspruch 11, **dadurch gekennzeichnet**, daß auf eine Unterlage (21) mit isolierender Oberfläche (22) Kontaktierungsflächen (23A, 23B;24A, 24B) derart aufgebracht werden, daß jeweils eine relativ große Kontaktierungsfläche (23A,24A) mit einer am Rand liegenden Kontaktierungsfläche (23B,24B) durch Leiterbahnen (25) verbunden wird, und daß zum Verbinden des aus dem Verbundmaterialband abgetrennten Widerstands (10) mit der Unterlage (21) die Anschlußteile (1,2) des Widerstands (10) mit den relativ großen Kontaktierungsflächen (23A,24A) vermittels eines Weichlots (27) verbunden werden.

13. Verfahren nach einem der Ansprüche 4 bis 12, **dadurch gekennzeichnet**, daß an die Anschlußteile (1,2) Stromanschlußschrauben (11A,11B) angebracht werden.

14. Verwendung eines Widerstands nach einem der vorangehenden Ansprüche zur Oberflächenmontage auf einer mit flächenförmigen Anschlußleitern versehenen Unterlage, wobei die angeschweißten Leitermetallteile auf die Anschlußleiter der Unterlage aufgelötet werden.

## Claims

1. Electrical resistor, particularly low resistance measuring resistor, with two metallic connector portions (1, 2) of high conductivity separated from one another to which conductors for the current flowing through the resistor are connectable and with a resistive element (3) comprising a resistive alloy which is inserted between the connector portions (1, 2) and electrically and mechanically connects them, characterised in that the two connector portions (1, 2) and the resistive element (3) are of plate-shaped construction and the two connector portions (1, 2) are welded to the edges (4) of the plate-shaped resistive element (3).

2. Electrical resistor, particularly low resistance measuring resistor, with two metallic connector portions (1') of high conductivity separated from one another to which the conductors for the current flowing through the resistor are connectable and with a resistive element (3') comprising a resistive alloy which electrically and mechanically connects the connector portions (1'), characterised in that the two connector portions (1') and the resistive element (3) are of plate-shaped construction and the two connector portions (1') are welded on one side of the resistive element (3') to its edge, whereby slot (6), which separates the two connector portions (1') from one another, extends into the resistive element (3').

3. Electrical resistor, particularly low resistance measuring resistor, with two metallic connector portions (1, 2) of high conductivity separated from one another to which the conductors for the current flowing through the resistor and additional conductors for voltage-pickup are connectable and with a resistive element (3) comprising a resistive alloy, which is inserted between the connector portions (1, 2) and electrically and mechanically connects them, characterised in that the connector portions (1, 2) are welded to the resistive element (3), that the resistive element (3) is disposed on a substrate (21), which is provided with contact surfaces (23A, 23B) which are welded to the connector portions (1, 2) by a soft solder, and that the contact surfaces (23A, 23B) are connected to separate connector surfaces (24A, 24B) by conductive tracks insulated from the resistive element (3) and the connector portions (1, 2).

4. Method of manufacturing electrical resistors, particularly low resistance resistors for measuring purposes or the like, whereby a resistive element comprising a resistive alloy is connected to connector portions of conductive metal of high electrical conductivity, characterised in that a long strip of the resistive alloy is initially welded continuously to a correspondingly long strip of the conductive metal at at least one of its longitudinal edges so that a strip of composite material is produced and that this strip is then cut up transverse to the strip longitudinal direction to produce a plurality of individual resistor portions.

5. Method as claimed in Claim 4, characterised in that the strips are continuously welded whilst passing through a welding station.

6. Method as claimed in Claim 4 or 5, characterised in that the strips are connected by electron beam welding.

7. Method as claimed in Claim 4 or 5, characterised in that the strips are connected by rolling seam welding.

8. Method as claimed in one of Claims 4 to 7, characterised in that a respective strip of a conductive metal is welded to both sides of the strip of the resistive alloy.

9. Method as claimed in one of Claims 4 to 8, characterised in that the composite material strip is rolled before the separation of the resistor portions so that it becomes substantially longer and wider.

10. Method as claimed in one of Claims 4 to 9, characterised in that a resistor portion with connector portions of the conductive metal separated from one another is formed from a strip separated or to be separated from the composite material strip transverse to the strip longitudinal direction by a slot which starts from an edge of the conductive metal portion extending in the strip longitudinal direction and extends through this portion transverse to the strip longitudinal direction into the alloy portion.

11. Method as claimed in one of Claims 4 to 10, characterised in that in order to produce a resistor with four-pole connectors, the resistor portion separated from the composite material strip is arranged on a substrate provided with metallic connector surfaces of high conductivity and the connector portions of the resistor portion comprising the connected metal are soldered to portions of these connector surfaces.

12. Method as claimed in Claim 11. characterised in that contact surfaces (23A, 23B; 24A, 24B) are applied to a substrate (21) with an insulating surface (22) such that in each case a relatively large contact surface (23A, 24A) is connected to a contact surface (23B, 24B) situated at the edge by conductive tracks (25) and that the connector portions (1, 2) of the resistor (10) are connected to the relatively large contact surfaces (23A, 24A) by means of a soft solder (27) in order to connect the resistor (10), separated from the composite material strip, to the substrate (21).

13. Method as claimed in one of Claims 4 to 12, characterised in that current connector screws (11A, 11B) are mounted on the connector portions (1, 2).

14. Use of a resistor as claimed in one of the preceding claims for surface mounting on a substrate provided with flat connecting conductors, the welded conductive metal portions being soldered to the connecting conductors of the substrate.

## Revendications

1. Résistance électrique, en particulier résistance de mesure faiblement ohmique, avec deux parties de raccordement (1, 2) séparées l'une de l'autre en métal à haute conductibilité, à laquelle peuvent être accordés les conducteurs destinés au courant passant dans la résistance et avec un élément résistant (3) inséré entre les parties de raccordement (1, 2) reliant celles-ci électriquement et mécaniquement et constitué d'un alliage résistant, caractérisée en ce que les deux parties de raccordement (1, 2) et l'élément résistant (3) sont réalisés sous forme de plaque et les deux parties de raccordement (1, 2) sont soudées aux arêtes (4) de l'élément résistant (3) sous forme de plaque.

2. Résistance électrique, en particulier résistance de mesure faiblement ohmique, avec deux parties de raccordement (1') séparées l'une de l'autre en métal à haute conductibilité, à laquelle peuvent être accordés les conducteurs destinés au courant passant dans la résistance et avec un élément résistant (3') inséré entre les parties de raccordement (1') reliant celles-ci électriquement et mécaniquement et constitué d'un alliage résistant, caractérisée en ce que les deux parties de raccordement (1') et l'élément résistant (3') sont réalisés sous forme de plaque et les deux parties de raccordement (1') sont soudées sur une face de l'élément résistant (3'), sur son arête, une entaille (6) séparant l'une de l'autre les deux parties de raccordement (1') s'étendant jusque dans l'élément résistant (3').

3. Résistance électrique, en particulier résistance de mesure faiblement ohmique, avec deux parties de raccordement (1, 2) séparées l'une de l'autre en métal à haute conductibilité, à laquelle peuvent être accordés les conducteurs destinés au courant passant dans la résistance et avec un élément résistant (3) inséré entre les parties de raccordement (1, 2) reliant celles-ci électriquement et mécaniquement et constitué d'un alliage résistant, caractérisée en ce que les parties de raccordement (1, 2) sont soudées sur l'élément résistant (3), en ce que l'élément résistant (3) est disposé sur une base (21) pourvue de faces de contact (23A, 23B) reliées par brasage, au moyen d'une brasure tendre, aux parties de raccordement (1, 2),
et en ce que les faces de contact (23A, 23B) sont reliées à des faces de raccordement (24A, 24B) séparées par les pistes conductrices isolées de l'élément résistant (3) et des parties de raccordement (1, 2).

4. Procédé de fabrication de résistances électriques, en particulier de résistances faiblement ohmiques à des fins de mesure ou analogue, un élément résistant constitué d'un alliage résistant étant relié à des parties de raccordement en métal conducteur à conductibilité électrique élevée, caractérisé en ce que d'abord on soude une bande longue réalisée à partir de l'alliage résistant, de façon ininterrompue, sur au moins l'une de ses arêtes longitudinales, à une bande, de longueur correspondante, réalisée dans le métal conducteur, de sorte qu'une bande en matériau composite soit produite et que cette bande soit alors séparée pour produire une pluralité de pièces résistantes individuelles, la séparation se faisant chaque fois transversalement par rapport à la direction longitudinale de la bande.

5. Procédé selon la revendication 4, caractérisé en ce que les bandes sont soudées en continu lors du passage dans un poste de soudage.

6. Procédé selon la revendication 4 ou 5, caractérisé en ce que les bandes sont reliées par soudage par faisceau d'électrons.

7. Procédé selon la revendication 4 ou 5, caractérisé en ce que les bandes sont reliées par soudage à la molette.

8. Procédé selon l'une des revendications 4 à 7, caractérisé en ce qu'une bande constituée du matériau conducteur est rapportée par soudage sur chacun des deux côtés de la bande réalisée en alliage résistant.

9. Procédé selon l'une des revendications 4 à 8, caractérisé en ce que la bande de matériau composite est laminée avant séparation des pièces résistantes de sorte à être notablement plus longue et plus large.

10. Procédé selon l'une des revendications 4 à 9, caractérisé en ce qu'à partir d'une bande à séparer ou à découper transversalement par rapport à la direction longitudinale de la bande, en partant de la bande de matériau composite, au moyen d'une entaille qui s'étend, en partant d'une bande, courant dans la direction longitudinale de la bande, de la partie de métal conducteur, à travers cette partie transversalement par rapport à la direction longitudinale de la bande, dans la partie d'alliage, est constituée une pièce résistante à l'aide de parties de raccordement en métal conducteur, séparées l'une de l'autre.

11. Procédé selon l'une des revendications 4 à 10, caractérisé en ce que, pour produire une résistance avec quatre conducteurs de raccordement, on dispose la pièce résistante issue de la séparation à partir de la bande de matériau composite sur une base pourvue de faces de raccordement métalliques à conductibilité élevée et l'on brase les parties de raccordement constituées du métal conducteur de la pièce résistante avec des parties de ces faces de raccordement.

12. Procédé selon la revendication 11, caractérisé en ce que l'on applique sur une base (21) ayant une surface (22) isolante des faces de contact (23A, 23B; 24A, 24B), de manière que chaque fois on relie une face de contact (23A, 24A) relativement grande à une face de contact (238, 24B) située sur le bord, au moyen de bandes conductrices (25) et en ce que pour assurer la liaison de la résistance (10) issue de la séparation à partir de la bande de matériau composite, avec la base (21), on relie les parties de raccordement (1, 2) de la résistance (10) aux faces de contact (23A, 24A) relativement grandes au moyen d'une brasure tendre (27).

13. Procédé selon l'une des revendications 4 à 12, caractérisé en ce que l'on applique sur les parties de raccordement (1, 2) des vis de raccordement électrique (11A, 11B).

14. Utilisation d'une résistance selon l'une des revendications précédentes pour le montage en surface sur une base pourvue de conducteurs de raccordement plats, les parties métalliques conductrices rapportées par sondage sur les conducteurs de raccordement de la base étant montées par brasage.
